# DEMANDE DE BREVET EUROPEEN

(11) **EP 0 696 053 A1**
(43) Date de publication de la demande: **07.02.1996**
(21) Numéro de dépôt: 95201596.4
(22) Date de dépôt: 15.06.1995
(51) Int. Cl.: H01L 21/335, H01L 29/778

(54) **Procédé de réalisation d'un transistor à effet de champ à canal creusé**

(30) Priorité: 29.06.1994 FR 9408011
(71) Demandeur: LABORATOIRES D'ELECTRONIQUE PHILIPS, F-94450 Limeil-Brévannes (FR); Philips Electronics N.V., NL-5621 BA Eindhoven (NL)
(72) Inventeur: Frijlink, Peter Michael, F-75008 Paris (FR); Iost, Michel, F-75008 Paris (FR)
(74) Mandataire: Lottin, Claudine

(57) **Abrégé**

Procédé de réalisation d'un dispositif semiconducteur incluant un transistor à effet champ à canal creusé, comprenant la formation d'un empilement de couches sur un substrat (1), avec une couche active (13, 14) semiconductrice ayant un taux d'aluminium (Al) non nul, une couche chapeau (4) semiconductrice sans aluminium (Al), une couche de masquage (100) munie d'une ouverture de grille (51) ; une première gravure sélective, par un premier agent de gravure composé du fluor (F), dans la couche chapeau (4), jusqu'à la surface supérieure (22) de la couche active (13, 14), sur laquelle se forme automatiquement une couche d'arrêt (3) en fluorure d'aluminium (AlF₃) ; puis l'élimination de la couche d'arrêt (3) ; une seconde gravure non sélective dans la couche active (13, 14), par un second agent de gravure, jusqu'à formation complète d'un premier évidement central de grille (52, 42) ; une troisième gravure sélective, par le premier agent de gravure dans la couche chapeau (4), latéralement pour former les flancs (64) d'un second évidement dont le fond est la surface supérieure (22).
Application : Dispositifs semiconducteurs incluant des HEMTS

## Description

L'invention concerne un procédé de réalisation d'un dispositif semiconducteur incluant un transistor à effet de champ à canal creusé.

L'invention trouve tout particulièrement son application dans la réalisation de dispositifs semiconducteurs intégrés incluant des transistors à haute mobilité électronique (en anglais, High Electron Mobility Transistor : HEMT).

Un procédé de réalisation d'un transistor à effet de champ à canal creusé comprenant la formation d'un double évidement de grille (two stages gate recess en anglais) est déjà connu de l'état de la technique par la demande de brevet japonais publiée sous le N° 61-89681/86 (également disponible sous la forme d'abrégé en anglais).

Ce procédé connu comprend, pour réaliser le transistor à effet de champ spécifique, au moins les opérations suivantes :
- la formation des couches semiconductrices (substrat) et des contacts ohmiques de source et drain,
- la formation de deux couches de masquage superposées : une première couche purement diélectrique dite couche espaceur, et une seconde couche en photoresist :
- la gravure d'une ouverture de dimensions correspondant à la future grille, dans ces couches de masquage,
- la gravure d'un premier évidement, dit central, dans le matériau semiconducteur sous-jacent, jusqu'à une première profondeur, avec des dimensions transversales délimitées par celles de l'ouverture de la couche de photorésist,
- la gravure latérale de la première couche espaceur pour délimiter dans cette couche une ouverture élargie vers les côtés, sous la couche en photorésist,
- la gravure du matériau semiconducteur sous-jacent consistant en :
   . la reprise de gravure du premier évidement central jusqu'à une seconde profondeur plus grande que la première,
   . la gravure d'un second évidement dit périphérique, de dimensions transversales délimitées par celles de l'ouverture élargie formée dans la couche espaceur, et d'une profondeur intermédiaire entre la surface du matériau semiconducteur et le fond du premier évidement central,
- les gravures alternativement pratiquées dans la couche espaceur diélectrique et dans le matériau semiconducteur sous-jacent étant obtenues par des agents de gravure chimiques sélectifs, l'un pour le matériau diélectrique, l'autre pour le matériau semiconducteur.

Le résultat de ces différentes opérations est que le transistor montre un canal creusé sur deux niveaux, avec un premier évidement central ayant la plus faible dimension transversale et un niveau à la plus grande profondeur pour recevoir le métal de contact de grille, et avec un second évidement périphérique ayant la plus grande dimension transversale et un niveau à une profondeur intermédiaire entre celui de la surface du matériau semiconducteur et celui du premier évidement central.

Il résulte de l'enseignement du document cité que deux couches diélectriques (la couche espaceur et la photorésist) sont nécessaires pour mener à bien le procédé connu ; et que le niveau définitif du premier évidement central, qui reçoit le contact de grille, et qui définit donc l'épaisseur réelle du canal du transistor, est obtenu au moyen de deux gravures chimiques successives, c'est-à-dire d'une première étape de gravure jusqu'à une première profondeur, et d'une seconde étape de reprise de gravure jusqu'à une seconde profondeur.

Maintenant, la réalisation de transistors à effet de champ à canal creusé sur deux niveaux pose des problèmes de fabrication.

Un premier problème de fabrication réside dans le fait que, en réalité plusieurs milliers de transistors absolument identiques doivent être réalisés en même temps sur un substrat de grand diamètre (au moins 7cm). Si des moyens pour contrôler les profondeurs de gravure aux valeurs voulues ne sont pas fournis, alors les profondeurs gravées seront, d'une part imprécises et difficilement reproductibles, et d'autre part ces profondeurs seront différentes, considérées au centre ou sur les bords du substrat. Il en résultera la fabrication de transistors avec des dispersions des propriétés électroniques, donc des pertes de rendement de fabrication.

Le procédé connu présente l'inconvénient d'enseigner la réalisation du premier évidement central avec deux gravures successives, sans enseigner des moyens de contrôle de la profondeur précise de chacune de ces gravures, ou des moyens d'arrêt automatique de gravure à une profondeur précise voulue. La profondeur obtenue par les deux gravures successives sera donc imprécise et difficilement reproductible. Les transistors réalisés sur la surface totale d'un substrat montreront en outre des dispersions de leurs caractéristiques.

Un second problème de fabrication réside dans le fait que, le concepteur de circuits intégrés envisage maintenant des transistors de structure plus complexe que le transistor réalisé au moyen du procédé connu. Cependant, pour des raisons économiques, ces transistors plus complexes doivent être fabriqués avec le moins grand nombre possible d'étapes.

Le procédé connu présente l'inconvénient de mettre en oeuvre deux couches de masquage. Parmi ces deux couches, à la fin du procédé, la couche de photorésist est éliminée (LIFT-OFF) après la fabrication du contact métallique de grille, tandis que la couche espaceur est conservée comme couche de protection. Cependant le maintien de la couche espaceur ne constitue pas une protection suffisante, car cette couche présente l'inconvénient de ne pas protéger la région de grille. Il en résulte que cette couche est finalement inutile puisque le fabricant de circuit intégré devra envisager une couche supplémentaire de protection efficace, non décrite. Donc la formation de la couche espaceur allonge de manière défavorable le procédé connu.

Un autre problème de fabrication lié à la réalisation de transistors plus complexes que celui obtenu par le procédé connu, tient au fait qu'il n'est pas enseigné comment réaliser le canal creusé avec un double évidement de grille lorsque différents matériaux semiconducteurs disposés en couches successives sont rencontrés durant la gravure de ce double évidement.

Une solution doit être trouvée à ce dernier problème en tenant compte aussi des autres problèmes exposés au préalable, c'est-à-dire fournir une méthode où les profondeurs de gravure sont bien contrôlées, bien reproductibles, bien identiques sur toute la surface du substrat traité, et mise en oeuvre avec le moins d'étapes possible.

Selon l'invention, un procédé est proposé pour réaliser un transistor à effet de champ ayant des performances améliorées, évitant les inconvénients du procédé connu, et résolvant les problèmes énoncés.

Ces buts sont atteints au moyen d'un procédé de réalisation d'un dispositif semiconducteur incluant un transistor à effet champ à canal creusé, comprenant au moins :
- la réalisation d'un empilement de couches sur un substrat, parmi lesquelles successivement :
   . une couche active en un composé semiconducteur incluant un taux d'aluminium (Al) non nul, dans laquelle un premier évidement central est à creuser pour recevoir un contact Schottky de grille,
   . une couche chapeau en un composé semiconducteur sans aluminium (Al), pour recevoir les contacts ohmiques de source et drain du transistor,
   . une couche de masquage munie d'une ouverture dite ouverture de grille,
- la réalisation d'étapes de gravure pour creuser le premier évidement central de grille, par autoalignement sur l'ouverture de grille, parmi lesquelles successivement :
   . une première gravure sélective, avec un premier agent de gravure composé du fluor (F) pratiquée dans la couche chapeau, à travers l'ouverture de grille, et jusqu'à la surface supérieure de la couche active sur laquelle se forme automatiquement une couche d'arrêt en fluorure d'aluminium (AlF₃) par réaction du fluor de l'agent de gravure avec l'aluminium du composé semiconducteur de la couche active,
   . l'élimination de la couche d'arrêt en fluorure d'aluminium (AlF₃),
   . une seconde gravure non sélective pratiquée dans la couche active, à travers l'ouverture de grille, avec un second agent de gravure jusqu'à formation complète du premier évidement central de grille.

Un avantage présenté par ce procédé, est qu'il inclut la formation d'une couche dite chapeau (en anglais : cap layer), laquelle permet de diminuer les résistances d'accès de source et de drain.

Un autre avantage présenté par ce procédé est qu'il inclut la formation d'une couche d'un composé d'aluminium comme couche supérieure de canal, ce qui permet la formation d'une hétérostructure dans la couche de canal et donc la réalisation d'un transistor à haute mobilité électronique (HEMT).

Un autre avantage présenté par le procédé selon l'invention, est que l'on forme, non pas lors de la réalisation des couches semiconductrices avant toute étape de gravure, mais au contraire durant l'une des étapes de gravure elle-même, une couche d'arrêt de gravure de cette étape de gravure en cours, et que cette couche d'arrêt ainsi formée à des propriétés remarquables :
- elle se forme automatiquement pendant cette étape de gravure à une position reproductible qui est la face supérieure de la couche active, et ceci, sur l'entière surface du substrat traité,
- elle arrête automatiquement cette étape de gravure en cours à ce niveau qui sert de repère reproductible sur l'entière surface du substrat traité,
- elle se forme sous une épaisseur suffisamment grande pour arrêter l'étape de gravure en cours,
- elle se forme sous une épaisseur suffisamment faible pour être facilement éliminable sans allonger le procédé ou perturber les surfaces déjà formées : typiquement cette couche d'arrêt a une épaisseur d'une ou deux monocouches atomiques (0,3 à 0,6 nm).

Un autre avantage présenté par ce procédé est que la couche d'arrêt de gravure utilisée est éliminée en cours du procédé. Cet avantage consiste plus particulièrement dans le fait que cette couche d'arrêt n'existe plus dans le transistor fini, et donc que le transistor ainsi formé, contrairement aux transistors qui contiennent encore des couches d'arrêt une fois terminés, ne voit pas ses performances perturbées par ces couches parasites : il est en effet évident que, compte tenu des dimensions submicroniques impliquées dans les transistors, à ce jour, tout élément non nécessaire, ayant même de très faibles dimensions, vient perturber le fonctionnement ; par exemple il est connu que certaines couches d'arrêt maintenues en fin de procédé introduisent des résistances parasites, et produisent des effets de piégeage ; il est également connu que certaines couches d'arrêt dont la composition est au contraire capable de diminuer les résistances d'accès, ne tiennent pas en tension et produisent des claquages, particulièrement dans les transistors submicroniques actuels.

Un autre avantage présenté par le procédé selon l'invention est que le niveau du fond de la partie centrale du double évidement de grille est réalisé en une seule étape de gravure à partir d'un niveau bien défini par la couche d'arrêt. Par conséquent, ce niveau, dont la position est très importante pour définir l'épaisseur de la couche active, est ainsi obtenue par une étape de gravure qui peut être bien contrôlée, et est lui-même bien défini. En effet, à partir du moment où la couche d'arrêt a été éliminée, l'épaisseur de matériau qui est à graver dans la gravure non sélective est très petite, et donc l'erreur qui peut se produire sur une telle faible profondeur gravée ne peut être qu'excessivement petite. La précision sur la position de ce niveau du fond de cette partie centrale est de la plus haute importance quand on sait que les épaisseurs enrichies ou désertées, qui sont en jeu pour bloquer ou rendre passant le transistor, sont extrêmement faibles. Donc toute imprécision sur l'épaisseur finale du canal résulte en des variations catastrophiques des performances du transistor fini. Les performances du transistor selon l'invention sont donc assurées d'être très bonnes, fiables et reproductibles dans le cours du processus de fabrication de plusieurs milliers de transistors répartis sur une grande surface.

Dans une mise en oeuvre, ce procédé est caractérisé en ce qu'il comprend en outre, pour creuser un second évidement de grille, moins profond, et plus étendu latéralement que le premier,
- la réalisation d'étapes ultérieures de gravure, parmi lesquelles successivement :
   . une troisième étape de gravure sélective, avec le premier agent de gravure composé du fluor (F), pratiquée dans la couche chapeau uniquement latéralement pour former les flancs du second évidement dont le fond est constitué par la surface supérieure de la couche sous-jacente.

Dans cette mise en oeuvre, le transistor obtenu par le procédé montre une tension de claquage améliorée, sans détérioration des résistances d'accès. Le procédé mis en oeuvre pour atteindre ce but est particulièrement simple et donc avantageux sur le plan industriel. De plus, les étapes de réalisation du second évidement de grille ne détériorent pas le premier évidement de grille dont la précision est, comme on l'a vu, de la plus haute importance.

L'invention est décrite ci-après en détail, en référence avec les figures schématiques annexées parmi lesquelles :
- la FIG.1 représente un transistor à effet de champ à canal creusé sur deux niveaux,
- les FIG.2A à 2F représentent les différentes étapes du procédé pour réaliser le transistor de la FIG.1,
- la FIG.3 représente une variante avantageuse de l'empilement des couches semiconductrices pour réaliser un transistor HEMT pseudomorphique.

L'invention concerne un procédé de réalisation d'un dispositif semiconducteur comprenant, sur un substrat, au moins un transistor à canal creusé.

L'invention est décrite dans l'application à la réalisation de transistors à haute mobilité électronique (en anglais : High Electron Mobility Transistor HEMT) désigné ci-après par HEMT.

Les propriétés du HEMT considéré en tant que tel sont bien connues de l'homme du métier des circuits intégrés, tant numériques qu'analogiques, en toutes technologies, et de ce fait ne sont pas décrites ici plus avant.

D'une manière générale, le transistor HEMT comprend un empilement de couches dites actives réalisées sur un substrat 1, parmi lesquelles se trouvent au moins :
- une première couche 10 en un premier matériau de faible largeur de bande interdite, faiblement dopée ;
- une seconde couche active 13 en un second matériau de plus grande largeur de bande interdite, fortement dopée de type n⁺⁺, formant une hétérostructure avec la première couche 10, d'interface 20 ;
- une troisième couche 4, fortement dopée n⁺⁺, dite couche chapeau (en anglais : CAP LAYER),
- deux plots de contact ohmique 5A et 5B, pour former les contacts électriques de source et drain du transistor ; ces plots sont réalisés en surface de la couche chapeau au moyen d'un alliage métal/semiconducteur ;
- un plot métallique de grille 8 directement déposé sur le matériau de la couche active supérieure 13 pour former une barrière Schottky.

Cette barrière Schottky doit se trouver à une distance très précise du bas de la couche active 13, c'est-à-dire à une distance très précise de l'interface 20 de l'hétérostructure formée des couches 13/10.

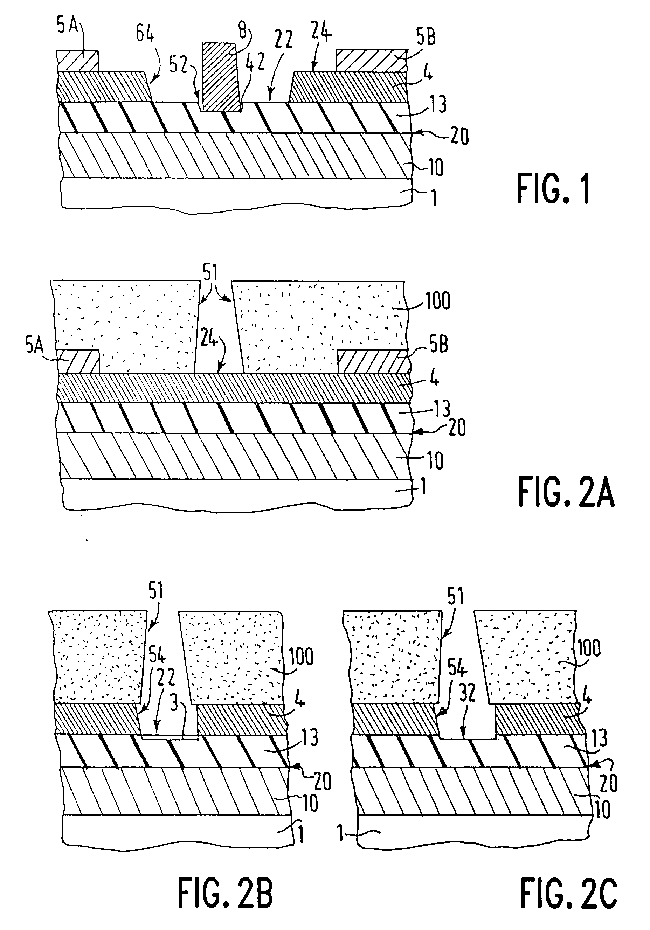

En référence avec la FIG.1, un meilleur fonctionnement et des meilleurs performances du transistor sont obtenus lorsque le contact de grille 8 est disposé dans un premier évidement 42, 52 (en anglais : FIRST RECESS) dont le fond 42 est à une distance précise de l'interface 20 d'hétérostructure. Cette distance représente l'épaisseur effective de la couche active 13. Cette épaisseur régit le fonctionnement du transistor, c'est-à-dire sa tension de pincement. Par exemple, selon le cas, le transistor sera du type à enrichissement (en anglais : ENHANCEMENT, Normally-OFF transistor) ou bien du type à désertion (en anglais : DEPLETION, Normally-ON transistor).

Il faut savoir que la mise en oeuvre réelle des transistors pose des problèmes de rendement de fabrication. Le rendement de fabrication est considéré comme bon si les performances des transistors sont uniformes sur toute la surface de plaquette de semiconducteur traitée (en anglais : WAFER) c'est-à-dire sont dans une fourchette de caractéristiques déterminées à l'avance. En particulier, ces performances doivent être uniformes d'un bord à l'autre de la plaquette (généralement d'un diamètre de 7,6 cm = 3") et d'une plaquette à l'autre.

A titre d'exemple, on peut citer qu'un transistor à effet de champ à enrichissement présente une distance entre le contact de grille 8 et l'interface 20 de l'hétérostructure de l'ordre de 20 nm, obtenue par creusement du canal dans la couche active supérieure 13, elle-même de l'ordre de 50 nm. Ce transistor travaille entre 200 mV et 700 mV, avec une tension de pincement de l'ordre de 350 mV. Toute erreur sur la localisation du fond de l'évidement de grille crée une erreur sur la tension de pincement. Par exemple, une erreur de la hauteur d'une monocouche de matériau cristallin semiconducteur (une monocouche ayant une épaisseur de l'ordre de 0,3 nm) sur la distance contact de grille 8-interface 20, entraîne une erreur de 22 mV sur la tension de pincement. Puisque l'épaisseur finale de la couche canal est déterminée par la localisation du fond de l'évidement de grille par rapport à la position de l'interface 20 de l'hétérostructure, il en résulte que, pour un transistor à enrichissement ayant une fourchette de fonctionnement aussi étroite, une erreur de localisation du fond de l'évidement de grille de quelques monocouches cristallines, entraîne une terrible variation des performances électriques d'un tel transistor.

C'est pourquoi, dans le procédé selon l'invention, des étapes sont proposées pour réaliser une localisation extrêmement précise du fond 42 de l'évidement qui reçoit le contact de grille 8, dit premier évidement de grille (FIRST RECESS), ou évidement central. L'avantage du procédé selon l'invention est de permettre cette localisation avec une précision plus grande que ne le permettait le procédé connu de l'état de la technique, et d'une manière générale de permettre cette localisation sans dépasser l'erreur permise, de seulement quelques monocouches cristallines de matériau semiconducteur. De plus, cette localisation est non seulement précise, mais aussi uniforme sur la totalité de la surface de la plaquette à traiter (WAFER).

Un transistor à effet de champ doit montrer en outre, d'une part une tension de claquage suffisamment élevée, et d'autre part des résistances d'accès suffisamment faibles.

Il a été trouvé que la valeur de la tension de claquage pouvait être augmentée en réalisant un transistor à effet de champ montrant une structure à double évidement de grille (en anglais DOUBLE RECESS), formant un canal creusé sur deux niveaux différents (en anglais : TWO STAGES RECESS).

En référence avec la FIG.1, le transistor HEMT comprend donc en outre un second évidement 22, 64 de grille (en anglais SECOND RECESS) dont le fond 22 est à un niveau différent de celui du fond 42 du premier évidement de grille 42, 52 comprenant le contact de grille 8. Le fond 22 de ce second évidement est à une distance plus grande de l'interface 20 de l'hétérostructure 13/10. Dit autrement le premier évidement de grille 42, 52 est plus profond que le second évidement de grille 22, 64.

En outre, le premier évidement de grille a des flancs peu éloignés du métal de contact de grille 8, alors que le second évidement de grille a des flancs 64 beaucoup plus éloignés de ce contact 8 ; c'est-à-dire a des dimensions transversales plus grandes.

Afin d'éviter néanmoins d'augmenter la résistance grille-source dans des proportions indésirables par la présence du second évidement de grille, un compromis doit être trouvé aux dimensions de ce second évidement. En effet, d'une part la distance entre le contact de grille 8 et le bord latéral du matériau semiconducteur doit être faible pour obtenir que les résistances d'accès soient petites. Et, d'autre part, cette distance doit être suffisamment grande pour éviter les claquages aux valeurs de tension élevées.

C'est pourquoi, dans le procédé selon l'invention, des étapes sont proposées pour réaliser la localisation extrêmement précise des flancs 52 du premier évidement ; du fond 22 du second évidement ; et des flancs 64 du second évidement.

Le procédé selon l'invention permet donc de localiser avec une grande précision le premier et le second évidement pour que le compromis voulu sur les dimensions de la structure à double évidement soit obtenu, et qu'une tension de claquage plus grande soit obtenue sans augmentation notable des résistances d'accès ; et ces localisations sont uniformes sur la surface totale de la plaquette support à traiter (WAFER).

En référence avec la FIG.1, la structure du transistor HEMT montre avantageusement la couche chapeau 4. Cette couche chapeau 4 a d'abord pour fonction de diminuer les résistances de source et de drain du transistor réalisé au moyen du procédé proposé par l'invention. En effet cette couche 4 fortement dopée n⁺⁺ augmente la conduction du matériau semiconducteur dans les régions situées sous les contacts ohmiques de source et drain 5A, 5B.

Cette couche chapeau 4 a aussi pour fonction d'éloigner de la région du canal, les régions sous-jacentes aux contacts ohmiques de source et drain, régions qui sont mécaniquement et électriquement perturbées lors de la fusion de l'eutectique pour former l'alliage métal-semiconducteur constituant les contacts ohmiques 5A et 5B.

La méthode selon l'invention pour réaliser le double évidement de grille avec la précision voulue dans une structure de transistor incluant la présence de la couche chapeau 4 est décrite ci-après en référence avec les FIG.2A à 2F.

Elle met en oeuvre la réalisation de gravures pratiquées dans cette structure, incluant, l'autoalignement de ces gravures sur l'ouverture du masque de contact de grille.

Donc, selon cette méthode, une seule couche de masquage classique, en photorésist par exemple, est utilisée, et non deux couches comme il était connu de l'état de la technique.

En référence avec la FIG.2A, le procédé comprend la formation de l'empilement des couches de matériaux semiconducteurs incluant au moins :
- la formation d'un substrat 1 en arséniure de gallium semi-isolant,
- la croissance d'une couche 10 en arséniure de gallium non dopée intentionnellement, d'épaisseur comprise entre 100 et 1000 nm, et de préférence d'épaisseur 400 nm, qui est la couche de faible largeur de bande interdite ;
- la croissance d'une couche 13 en arséniure de gallium et d'aluminium (GaAlAs) avec une concentration en aluminium (Al) de l'ordre de 22 %, fortement dopée de type n⁺⁺, par exemple au moyen d'espèces telles que le silicium (Si) à un taux supérieur ou égal à 10¹⁸ x cm⁻², d'épaisseur comprise entre 20 et 80 nm, et de préférence 50 nm qui est la couche de plus grande largeur de bande interdite que la couche 10 sous-jacente.

Ces couches peuvent être réalisées par croissance épitaxiale sur le substrat semi-isolant.

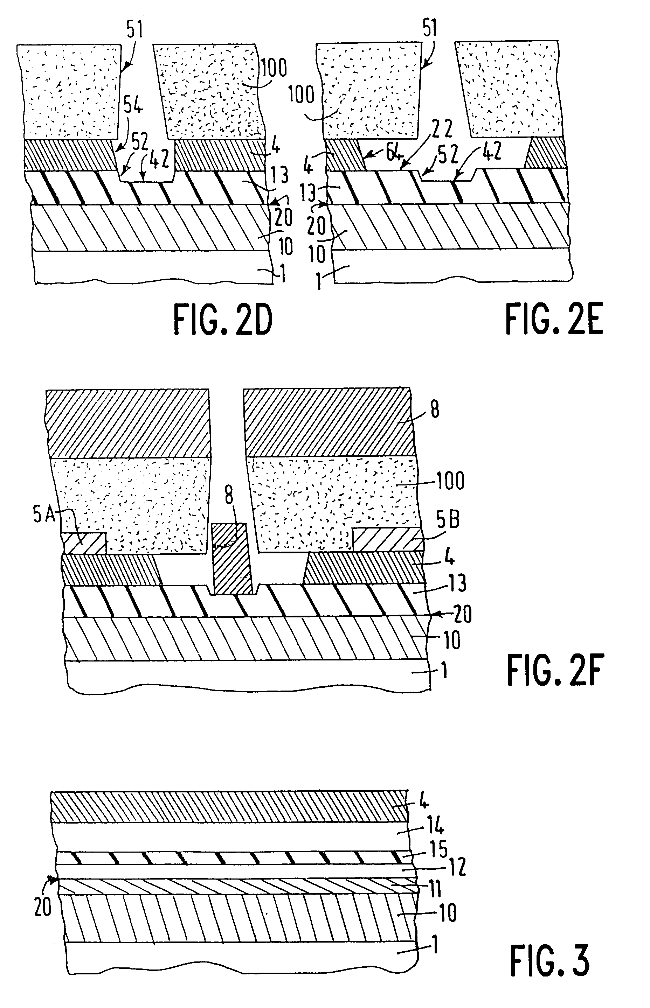

En référence avec la figure 3, dans une variante, cet empilement de couches peut comprendre, à partir du substrat 1 :
- la croissance de la couche 10 en arséniure de gallium (GaAs) non dopée intentionnellement, alors appelée couche tampon (en anglais : BUFFER), ayant les épaisseurs données plus haut pour la couche également référencée 10 ;
- la croissance d'une couche 11 en arséniure de gallium et d'indium (GaInAs), alors appelée couche canal (en anglais : CHANEL), ayant une concentration en indium de l'ordre de 22 %, non dopée intentionnellement, d'épaisseur comprise entre 0 et 30 nm, et de préférence 10 nm ;
- la croissance d'une couche 12, appelée couche espaceur (en anglais : SPACER), en arséniure de gallium et d'aluminium (GaAlAs), ayant une concentration en aluminium (Al) de l'ordre de 22 %, non dopée intentionnellement, d'épaisseur comprise entre 0 et 5 nm, et de préférence 3 nm ;
- la croissance d'une couche 15 en arséniure de gallium et d'aluminium (GaAlAs), dans ce cas appelée couche donneur (en anglais : CARRIER SUPPLYING LAYER), ayant une concentration en aluminium (Al) de l'ordre de 22 %, fortement dopée n⁺⁺ à un taux supérieur à 10¹⁸ x cm⁻³, d'épaisseur comprise entre 0,3 nm (une monocouche cristalline) et 40 nm, et de préférence 25 nm ;
- la croissance d'une couche 14, en arséniure de gallium et d'aluminium (GaAlAs), de ce cas appelée couche Schottky, ayant une concentration en aluminium (Al) de l'ordre de 22 %, non dopée intentionnellement, d'épaisseur 10 à 40 nm, et de préférence 25 nm ;
- la croissance de la couche chapeau 4 (CAP LAYER), en arséniure de gallium (GaAs), fortement dopée n⁺⁺ à un taux supérieur à 10¹⁸ x cm⁻³, d'épaisseur comprise entre 5 et 100 nm, et de préférence 50 nm.

Dans cet agencement de couches, le matériau d'arséniure de gallium et d'indium (GaInAs) pour réaliser la couche canal 11 présente une faible largeur de bande interdite, alors que le matériau d'arséniure de gallium et d'aluminium (GaAlAs) pour réaliser successivement la couche espaceur non dopée 12, la couche donneur fortement dopée 15 et la couche Schottky 14, présente une plus grande largeur de bande interdite. Dans ces conditions, un gaz bidimensionnel d'électrons s'établit à l'interface 20 des couches espaceur 12/canal 11, de largeurs de bande interdite différentes. Le HEMT présentant cet agencement est connu sous le nom de transistor à haute mobilité électronique, pseudomorphique, et fournit à ce jour de meilleures performances que le HEMT à structure plus simple décrit plus haut, car dans la structure pseudomorphique, la différence entre les largeurs de bande interdite des matériaux est plus grande.

Cependant le procédé selon l'invention peut s'appliquer à la réalisation de tout transistor à double évidement de grille dont l'empilement des couches, dans la partie supérieure duquel ce double évidement est creusé, comprend au moins :
- une couche supérieure 13 ou 14 sur laquelle le contact Schottky est formé dans undit premier évidement, dont le matériau semiconducteur inclut au moins un taux d'aluminium non nul ; par taux non nul, on entend qu'une concentration en aluminium (Al) de 0,1 dans la formule du composé semiconducteur est déjà suffisante pour pouvoir mettre en oeuvre l'invention ;
- une couche chapeau 4 dont le matériau semiconducteur n'inclut pas d'aluminium.

A la suite de la réalisation de l'empilement des couches de matériaux semiconducteurs, par exemple par croissance épitaxiale, en mettant en oeuvre favorablement une technique connue de l'homme du métier telle que l'épitaxie par jet moléculaire (en anglais : MOLECULAR BEAM EPITAXY, MBE) ou le dépôt en phase vapeur aux organométallic (en anglais : ORGANIC CHEMICAL VAPOR DEPOSITION, MOCVD), le procédé de réalisation du transistor comprend :
- la réalisation des contacts ohmiques de source et drain 5A et 5B, par toute méthode connue de l'homme du métier.

Puis le procédé de réalisation du double évidement de grille est mis en oeuvre. Ce procédé comprend spécifiquement selon l'invention :
- en référence avec la FIG.2A, la formation d'un masque 100, en photorésist, muni d'une ouverture 51, qui peut être micronique ou submicronique, pour délimiter le futur contact de grille 8 ; toutes les ouvertures ultérieures impliquées dans ce procédé se trouveront auto-alignées sur cette ouverture de grille 51 ; cette ouverture de grille 51 découvre la surface supérieure 24 de la couche chapeau 4. La réalisation du masque 100 à la précision micronique ou submicronique est mise en oeuvre par toute méthode connue de l'homme du métier, par exemple par écriture par faisceau d'électrons (en anglais : ELECTRON-BEAM) délimitant des ouvertures de grille microniques ou submicroniques ;
- en référence avec la FIG.2B, la gravure d'une ouverture ayant des flancs 54, formée dans la couche chapeau 4, jusqu'à la surface supérieure 22 de la couche sous-jacente référencée 13 ou bien 14 (selon qu'un HEMT ou un HEMT pseudomorphique est réalisé), en matériau semiconducteur incluant l'élément aluminium (Al) ; cette gravure est mise en oeuvre par une méthode de gravure ionique réactive (en anglais RIE) avec un plasma formé d'un agent composé incluant au moins le fluor (F), avec par exemple le chlore (Cl) ; par exemple, favorablement le plasma utilisé peut inclure C₂Cl₂F₂, ou bien une association de SiCl₄ et SF₆ ; dans ces conditions, la gravure du matériau de la couche chapeau 4, qui est, dans l'exemple décrit, de l'arséniure de gallium (GaAs), est sélective vis-à-vis du matériau de la couche sous-jacente 13 ou 14, qui est, dans l'exemple décrit, de l'arséniure de gallium et d'aluminium (GaAlAs).

Selon le procédé conforme à l'invention, cette étape de gravure s'ARRETE AUTOMATIQUEMENT au niveau de la surface supérieure 22 de la couche sous-jacente 13 ou 14, grâce à la formation SYSTEMATIQUE d'une couche d'arrêt 3 de flurorure d'aluminium (AlF₃) par réaction de l'élément fluor (F) présent dans l'agent de gravure, sur l'élément aluminium (Al) present dans le matériau (GaAlAs) de cette couche sous-jacente 13 ou 14 ; cette couche d'arrêt 3 a généralement une épaisseur spontanée de une ou deux monocouches atomiques (0,3 à 0,6 nm) ;
- en référence avec la FIG.2C, l'élimination de la couche d'arrêt 3 en fluorure d'aluminium (AlF₃), formée systématiquement dans l'étape précédente, par lavage au moyen d'une opération simple d'immersion de la plaquette support 1 (WAFER) dans l'eau ; il en résulte l'apparition d'une surface 32 du matériau de la couche sous-jacente 13 ou 14 en arséniure de gallium et d'aluminium (GaAlAs) ; la couche d'arrêt 3 s'élimine de cette façon simple parce qu'elle est très mince ;
- en référence avec la FIG.2D, la gravure dudit premier évidement central de grille 52, 42, à travers les ouvertures 51 dans la couche de photorésist 100, et 54 dans la couche chapeau 4.

Cette gravure peut être mise en oeuvre par une méthode de gravure ionique réactive (RIE) avec un plasma incluant un agent de gravure sans fluor tel que Cl₂ ou BCl₃.

Dans une variante avantageuse, cette gravure peut être mise en oeuvre par voie humide, au moyen d'un mélange de H₃PO₄ ou H₃NO₄, plus H₂O₂, plus H₂O, dans les proportions 3 : 1 : 20. L'avantage est que les surfaces gravées obtenues sont nettes et non perturbées par le processus de gravure.

Cette étape mise en oeuvre par l'une ou l'autre des méthodes citées, permet la localisation précise du fond 42 du premier évidement de grille par rapport à la surface supérieure 22 de la couche gravée 13 ou 14, du fait que cette surface 22 était marquée par la couche d'arrêt 3 et sert maintenant de repère pour le niveau de départ de la gravure du premier évidement central de grille, et du fait que l'épaisseur à graver dans cette étape est toujours petite : un ordre de grandeur de cette épaisseur de gravure est environ 6 nm pour obtenir un transistor à désertion et 15 nm pour obtenir un transistor à enrichissement, lorsque la couche active a une épaisseur de 50 nm vis-à-vis de l'interface de l'hétérostructure.

L'homme du métier sait réaliser une telle étape de gravure avec la précision requise d'au plus quelques monocouches de matériau semiconducteur parce que cette gravure part d'une surface 22 bien localisée, et que la totalité de l'opération de gravure pour obtenir le fond 42 du premier évidement se fait en continu, en une seule étape.

Le taux de gravure est une fonction connue, avec une bonne précision, de la concentration de l'agent de gravure ; la profondeur gravée est une fonction du taux de gravure et du temps de gravure.

Du fait que l'épaisseur à graver est petite (6 à 15 nm), l'erreur qui peut se produire sur l'épaisseur gravée, d'une extrémité à l'autre de la plaquette support est faible ; la précision de l'ensemble des transistors de la plaquette reste dans la fourchette de précision envisagée. Des test électriques peuvent être faits, dans le cours du processus de gravure pour vérifier des paramètres fonctions de l'épaisseur gravée.

Au contraire dans l'état de la technique, la localisation de ce fond de premier évidement n'était pas précise, parce qu'il était atteint en deux étapes, avec reprise de gravure.

Un autre avantage de l'invention est que la couche d'arrêt 3, dont la surface coïncidait avec celle de l'ouverture de grille, est maintenant éliminée. Le transistor terminé n'inclut donc pas de parties non éliminées de couches d'arrêt de gravure qui, quand elles subsistent créent des résistances parasites ; ou des puits avec des effets de piégeage, ou bien au contraire engendre des possibilités de claquages.
- en référence avec la FIG.2E, la gravure du second évidement de grille dont les flancs sont référencés 64, et dont le fond est constitué par la surface supérieure 22 ; cette gravure est opérée dans la couche chapeau 4, par gravure ionique réactive (RIE) au moyen du plasma de la première gravure RIE avec les agents de gravure tels que CCl₂F₂ ou une association de SiCl₄ et SF₆, qui permet la gravure sélective de la couche chapeau 4 en GaAs vis-à-vis de la couche sous-jacente 13 ou 14 en GaAlAs. Cette gravure, du fait qu'elle est sélective, est donc uniquement latérale dans la couche chapeau 4. L'homme du métier sait contrôler une telle gravure par le taux de gravure et le temps de gravure, pour obtenir une dimension transversale très précise de ce second évidement de grille, dont la profondeur est définie avec précision du fait qu'elle ne peut aller au-delà de la surface supérieure 22 de la couche sous-jacente 13 ou 14. Dans cette étape de gravure, le premier évidement central de grille n'est évidemment pas approfondi ;
- dans le cas où la gravure de l'évidement 52, 42 a été faite par RIE, on prévoit éventuellement le traitement par voie humide (WET ETCHING) pour éliminer, sur un très petit nombre de monocouches, les contraintes et défauts produits dans cette étape de gravure sèche, au moyen d'un mélange H₃PO₄ ou H₃NO₄, plus H₂O₂ plus H₂O, dans les proportions 3 : 1 : 20. Ou bien encore, pour éliminer ces contraintes, on peut prévoir un recuit.
- en référence avec la FIG.2F, le dépôt d'une couche métallique 8, 80 ; ce dépôt s'effectue à travers l'ouverture de grille 51 pour réaliser le plot métallique de grille 8 à la précision de cette ouverture de grille 51 et en contact avec le fond 42 du premier évidement central ; ce dépôt s'effectue aussi en surface de la couche de photorésist 100 ; cette couche de photorésist 100 est ensuite éliminée par une méthode de LIFT-OFF connue, entraînant la portion (80) de couche métallique autre que celle nécessaire au plot de grille 8.

## Revendications

1. Procédé de réalisation d'un dispositif semiconducteur incluant un transistor à effet champ à canal creusé, comprenant au moins :
- la réalisation d'un empilement de couches sur un substrat (1), parmi lesquelles successivement :
. une couche active (13, 14) en un composé semiconducteur incluant un taux d'aluminium (Al) non nul, dans laquelle un premier évidement central (52, 42) est à creuser pour recevoir un contact Schottky (8) de grille,
. une couche chapeau (4) en un composé semiconducteur sans aluminium (Al), pour recevoir les contacts ohmiques de source et drain (5A, 5B) du transistor,
. une couche de masquage (100) munie d'une ouverture dite ouverture de grille (51),
- la réalisation d'étapes de gravure pour creuser le premier évidement central de grille, par autoalignement sur l'ouverture de grille parmi lesquelles successivement :
. une première gravure sélective, avec un premier agent de gravure composé du fluor (F), pratiquée dans la couche chapeau (4), à travers l'ouverture de grille (51), et jusqu'à la surface supérieure (22) de la couche active (13, 14), sur laquelle se forme automatiquement une couche d'arrêt (3) en fluorure d'aluminium (AlF₃) par réaction du fluor (F) de l'agent de gravure avec l'aluminium (Al) du composé semiconducteur de la couche active,
. l'élimination de la couche d'arrêt (3) en fluorure d'aluminium (AlF₃),
. une seconde gravure non sélective pratiquée dans la couche active (13, 14), à travers l'ouverture de grille (51) avec un second agent de gravure, jusqu'à formation complète du premier évidement central de grille (52, 42).

2. Procédé selon la revendication 1, caractérisé en ce qu'il comprend en outre, pour creuser un second évidement de grille (64, 22), moins profond, et plus étendu latéralement que le premier,
- la réalisation d'étapes ultérieures de gravure, parmi lesquelles successivement :
. une troisième étape de gravure sélective, avec le premier agent de gravure composé du fluor (F), pratiquée dans la couche chapeau (4) uniquement latéralement pour former les flancs (64) du second évidement dont le fond est constitué par la surface supérieure (22) de la couche sous-jacente (13, 14).

3. Procédé selon l'une des revendications 1 ou 2, caractérisé en ce que le première étape de gravure sélective, et la troisième étape de gravure sélective quand elle existe, sont pratiquées par gravure ionique réactive (RIE) à l'aide d'un plasma incluant un composé du fluor qui peut être C₂Cl₂F₂ ou une association de SiCl₄ et SF₆.

4. Procédé selon l'une des revendications 1 à 3, caractérisé en ce que la seconde étape de gravure non sélective est pratiquée par gravure ionique réactive (RIE) à l'aide d'un plasma incluant un composé sans fluor qui peut comprendre Cl₂ ou BCl₃.

5. Procédé selon la revendication 4, caractérisé en ce qu'il comprend un traitement final après les trois étapes de gravure pour éliminer les contraintes et défauts superficiels des surfaces gravées par RIE, au moyen d'un mélange H₃ PO₄ ou bien H₃ NO₄, avec H₂O₂ et H₂O, dans les proportions 3 : 1 : 20.

6. Procédé selon l'une des revendications 1 à 3, caractérisé en ce que la seconde étape de gravure non sélective est pratiquée par voie humide avec un agent de gravure composé sans fluor tel que par exemple un mélange de H₃PO₄ ou bien H₃NO₄ avec H₂O₂ et H₂O dans les proportions respectives 3 : 1 : 20.

7. Procédé selon l'une des revendications 2 à 6, caractérisé en ce que :
. l'élimination de la couche d'arrêt (3) en fluorure d'aluminium est faite par lavage à l'eau (H₂O),

8. Procédé selon l'une des revendications 1 à 5, caractérisé en ce que, pour former un transistor à effet de champ à haute mobilité électronique (HEMT) l'empilement de couches semiconductrices à partir du substrat (1) comprend au moins successivement :
- une première couche (10) en un composé semiconducteur de petite largeur de bande interdite,
- une seconde couche (13) en un composé semiconducteur incluant un taux non nul d'aluminium, de plus grande largeur de bande interdite et fortement dopée pour former une hétérostructure avec la première couche (10), seconde couche dans laquelle le premier évidement (52, 42) de grille est formé pour recevoir un contact Schottky de grille (8), la distance entre le fond (42) de ce premier évidement et l'interface (20) de l'hétérostructure étant strictement contrôlée pour obtenir un transistor ayant une tension de pincement à une valeur donnée, tel qu'un transistor du type à enrichissement ou à désertion ;
- la couche chapeau (4) fortement dopée pour recevoir les contacts ohmiques.

9. Procédé selon l'une des revendications 1 à 7, caractérisé en ce que, pour former un transistor à effet de champ à haute mobilité électronique (HEMT) pseudomorphique, l'empilement de couches semiconductrices à partir du substrat comprend :
- une couche dite tampon (10), non dopée intentionnellement en un composé semiconducteur de faible largeur de bande interdite,
- une couche dite canal (11), non dopée intentionnellement en un composé semiconducteur de faible largeur de bande interdite,
- une couche dite espaceur (12) non dopée intentionnellement en un composé semiconducteur de grande largeur de bande interdite formant une hétérostructure avec la couche sous-jacente de faible largeur de bande interdite,
- une couche dite donneur (15) fortement dopée, en un composé semiconducteur de grande largeur de bande interdite,
- une couche dite Schottky (14), non dopée intentionnellement incluant un taux d'aluminium non nul, de grande largeur de bande interdite dans laquelle le premier évidement (52,42) de grille est formé pour recevoir un contact Schottky (8) de grille, la distance entre le fond de ce dernier évidement et l'interface (20) de l' hétérostructure étant strictement contrôlé pour obtenir un transistor ayant une tension de pincement à une valeur donnée, tel qu'un transistor à désertion, ou un transistor à enrichissement,
- la couche chapeau (4) fortement dopée pour recevoir les contacts ohmiques de source et drain.

10. Procédé selon l'une des revendications 8 ou 9, caractérisé en ce que le composé semiconducteur de faible largeur de bande interdite est de l'arséniure de gallium (GaAs), ou de l'arséniure de gallium et d'indium (GaInAs), en ce que le composé semiconducteur de grande largeur de bande interdite est l'arséniure de gallium et d'aluminium (GaAlAs) et en ce que le substrat et la couche chapeau sont en arséniure de gallium (GaAs).
